Europäisches Patentamt

European Patent Office

Office européen des brevets

(11) Publication number: **0 496 002 A1**

## EUROPEAN PATENT APPLICATION
### published in accordance with Art. 158(3) EPC

(21) Application number: 91914602.7

(22) Date of filing: 20.08.91

(86) International application number:
PCT/JP91/01106

(87) International publication number:
WO 92/03780 (05.03.92 92/06)

(51) Int. Cl.5: **G06F 9/30, G06F 9/34**

(30) Priority: 20.08.90 JP 217135/90

(43) Date of publication of application:
29.07.92 Bulletin 92/31

(84) Designated Contracting States:
DE FR GB

(71) Applicant: **FUJITSU LIMITED**
**1015, Kamikodanaka Nakahara-ku**
**Kawasaki-shi Kanagawa 211(JP)**

(72) Inventor: **MIYAKE, Tomu Fujitsu Limited**
**1015, Kamikodanaka Nakahara-ku**
**Kawasaki-shi Kanagawa 211(JP)**

(74) Representative: **Skone James, Robert Edmund**
**GILL JENNINGS & EVERY 53-64 Chancery**
**Lane**
**London WC2A 1HN(GB)**

(54) **REGISTER CIRCUIT.**

(57) A compact register circuit which can rewrite the data of a specified bit without effect to the other bits and without reading the register value by one writing operation, and can perform a bit processing rapidly. The register has a latch circuit (3) which is in connection with a data bus (2) and which, when the value of the data bus is written, takes in and holds it, and a read circuit (4) for outputting the output of the latch circuit (3) to the data bus when reading it. Further, a second read circuit (7), which feeds the output (Q) of the latch circuit (3) to the data bus even at a time other than the time when the output (Q) is read according to a predetermined control signal, is provided in this register. The value of the register is updated only when the data keeps a specified logic level at the time of writing it.

Fig.3

ILLUSTRATION OF PRINCIPAL OF INVENTION AND ONE
EMBODIMENT OF INVENTION

FIELD OF THE INVENTION

The present invention relates to a register circuit, more particularly to a register circuit for use in a control microcomputer.

BACKGROUND ART

In control microcomputers, a bit process of registers is frequently used for performing control of the peripheral circuits. On the other hand, by increasing complexity of control, a higher processing speed is required.

Therefore, in the control microcomputer, it is necessary to realize high speed bit processing with a compact circuit.

In general, the register in the microcomputer is provided with a construction of a four bits unit or an eight bits unit adapted to the data width to be handled by the CPU. Accordingly, in the case that a writing operation is performed for only one bit, it is often performed to once read out the value in the register and again write in the value with a modification only for the desired bit. Although microcomputers having special instructions for bit processing are available, typical bit processing instructions are only capable of performing the above-mentioned operation with one instruction and thus performs substantially the same internal process as set forth above.

Namely, in the prior art, when the register is composed of a plurality of unit bit registers, if the bit process, such as setting or resetting one specific bit, is performed for processing the specific bit, data can be written in an other bit since the process is normally performed with respect to unit bits, i.e. four bits or eight bits.

Therefore, in order to process only the specific bit while maintaining other bits unchanged, it is required to perform an operation to change the specific bit into "1" or "0" and re-write it, for example.

Namely, disregarding whether the process is to be performed by software or by a CPU, two extra steps are required when arithmetic processing is required.

Accordingly, a longer process period in an arithmetic operation is required problems can occur when data varies between a timing of writing and a timing of reading.

Furthermore, since the read out value is used, a problem occures in that the registers exclusive for writing or the registers that differentiate the meaning between writing and reading cannot be used.

The object of the present invention is to solve the above-mentioned problems in the prior art and thus provide a register circuit that can write data to the specific bit without requiring reading of the register value and without affecting other bits, and is compact.

DISCLOSURE OF THE INVENTION

In order to accomplish the above-mentioned objects, the present invention employs the basic technical construction set out below. Namely, there is provided a register circuit including
a latch circuit connected to a data bus and obtaining a value of the data bus for holding upon writing; and
a register read out circuit outputting the output of the latch circuit to the data bus upon reading,
characterized by a feedback circuit feeding back the output of the latch circuit even at a timing other than the reading timing by a predetermined control signal. According to one aspect of the invention, the register circuit includes
a latch circuit connected to a data bus and obtaining a value of the data bus for holding upon writing; and
a register read out circuit outputting the output of the latch circuit to the data bus upon reading,
characterized by a second register read out circuit outputting the output of the latch circuit to the data bus even at a timing other than the reading timing by a predetermined control signal, and by updating a value of the register being performed only when the data at writing is at a specific logical level.

In another aspect of the register circuit according to the invention in the register circuit including
a latch circuit connected to a data bus and obtaining a value of the data bus for holding upon writing; and
a register read out circuit outputting the output of the latch circuit to the data bus upon reading,
characterized by a feedback circuit for feeding back the output of the latch circuit to the latch circuit not through the data bus even at a timing other than the reading timing, by the predetermined control signal.

BRIEF DESCRIPTION OF THE DRAWINGS

Fig. 1 is a schematic illustration of the construction of the conventional microcomputer, which shows the field of application of a register according to the present invention;
Fig. 2 is a schematic diagram of the conventional microcomputer;
Fig. 3 is an schematic diagram showing the principal of the register according to the present invention, and shows one practical construction of the present invention;
Fig. 4 is a schematic diagram showing another embodiment of the register circuit according to the present invention;

Fig. 5 is a schematic diagram showing a further embodiment of the register circuit according to the present invention;

Fig. 6 is a schematic diagram of one embodiment of the register circuit according to another aspect of the invention;

Fig. 7 is a schematic diagram in a condition, in which the register circuit according to the present invention is installed in a microcomputer; and

Fig. 8 are flowcharts demonstrating the effect of the microcomputer employing the register circuit according to the present invention.

BEST MODE FOR IMPLEMENTING THE INVENTION

The preferred embodiments of a register circuit according to the present invention will be discussed herebelow with reference to the drawings.

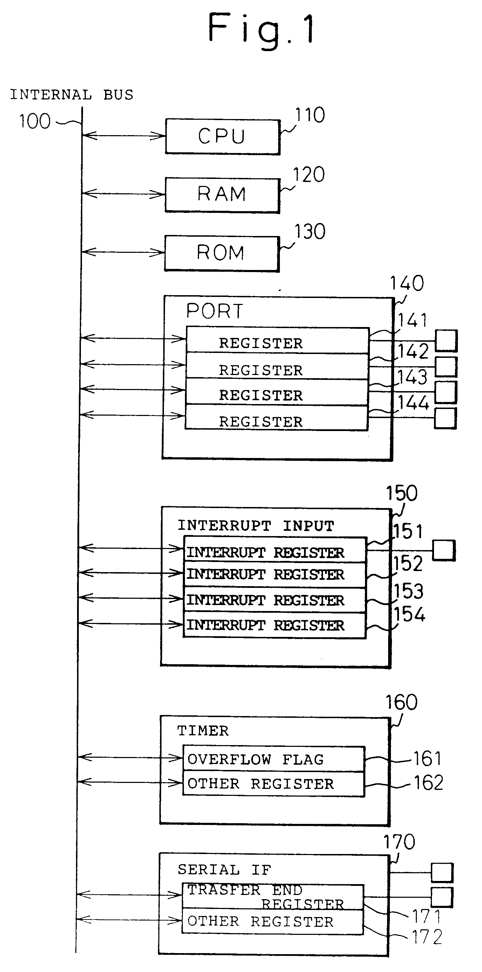

At first, an example of a field in which the register circuit according to the present invention is applicable is shown in Fig. 1.

In Fig. 1, there is illustrated a processor that comprises CPU 110, RAM 120, ROM 130, an output port 140, an interrupt input 150. a timer 160, serial interface 107 and so forth, connected through an internal bus line 100. Among these, the register is applicable as registers (in the shown embodiment, four bit construction) 141 to 144 provided in the output port 140, interrupt register 151 provided in the interrupt input 150, control registers 152 to 154 (even in this example, four bit construction is shown), and overflow flag 151 or other registers 162, transfer end flag 171 or other registers 172 provided in the timer 150 and the serial interface 107.

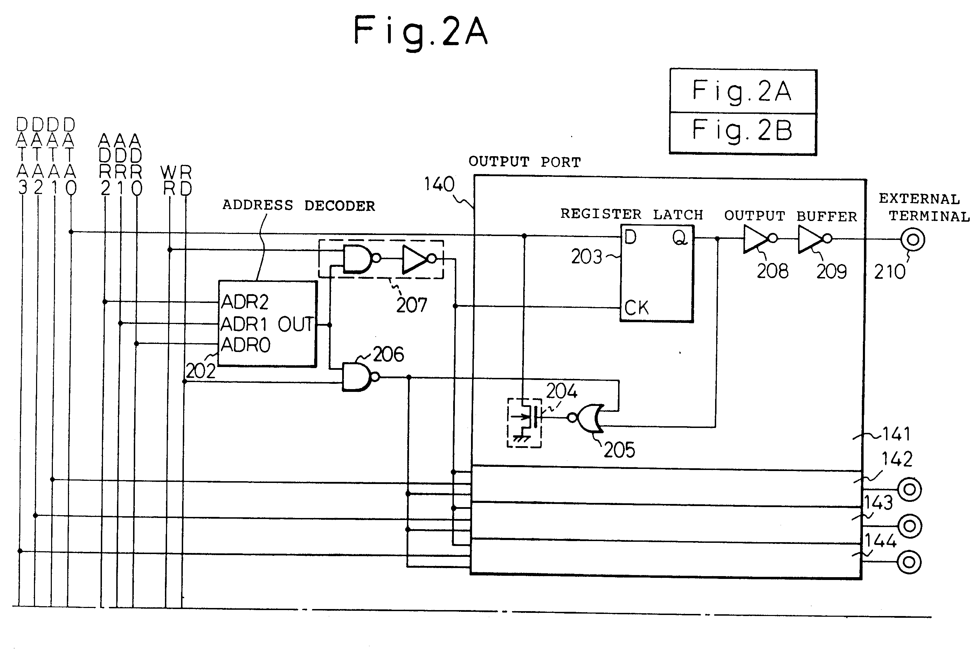

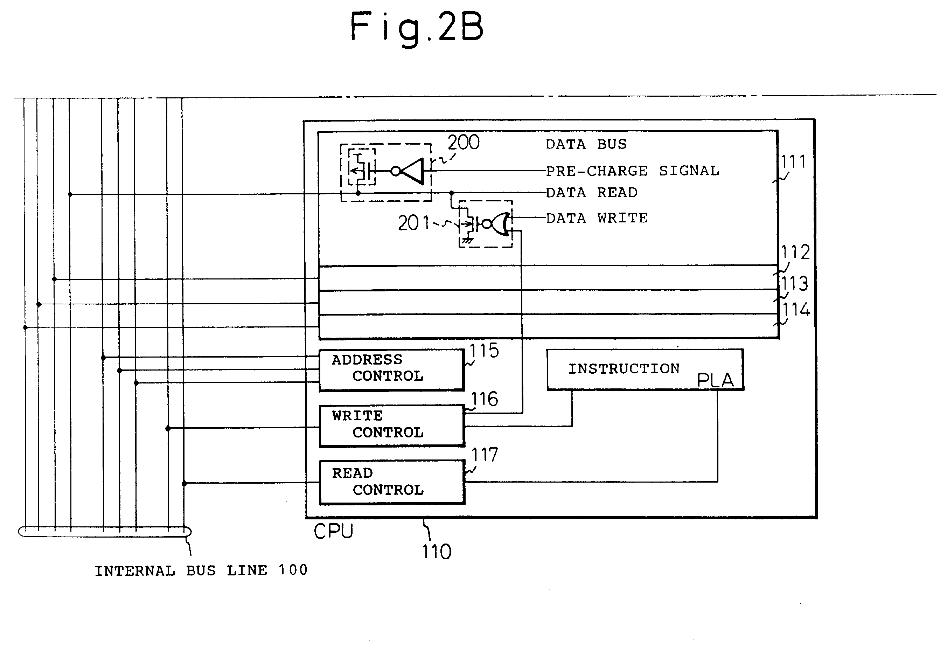

On the other hand, Fig. 2 is an enlarged illustration showing the construction of the conventional CPU 110 and the output port 140. The internal bus line 100 is composed for four bit construction, for example, including data lines DATA0 to 3, address lines ADR0 to 3, a write line WR and a read line RD. On the other hand, the CPU 110 is connected to respective data lines DATA0 to 3, and comprises a data pre-charge circuit 200, data control circuits 111 to 114 incorporating data writing circuits 201, an address control circuit 115, a write control circuit 116, a read control circuit 117 and an instruction PLA 118 controlling the write control circuit 116 and the read control circuit 117. Each of the registers 141 to 144 of the output port 140 comprises an address decoder 202, a register latch circuit 203, an AND gate that receives the output of the address decoder 202 and the write signal WR and has the output connected to the CK terminal of the register latch circuit 203; a NAND gate 206 that receives the output of the address decoder and the read signal RD and has the output connected to the CK terminal of the register latch circuit 203; a FET transistor 204 interposed between the input terminal D of the register latch circuit 203 and the ground (GDN), and a NAND gate that receives the output of the NAND gate 206 and the output at the Q output terminal of the register latch circuit 203 and has the output connected to the gate of the transistor 204. The Q output terminal of the register latch circuit 203 is connected to an external terminal 210 through inverters 208 and 209.

In the conventional register circuit constructed as illustrated in Fig. 2, the above-mentioned problems are encountered. Therefore, the inventors have made an extensive study and have improved the defects in the prior art by employing the register circuit having the construction set out below.

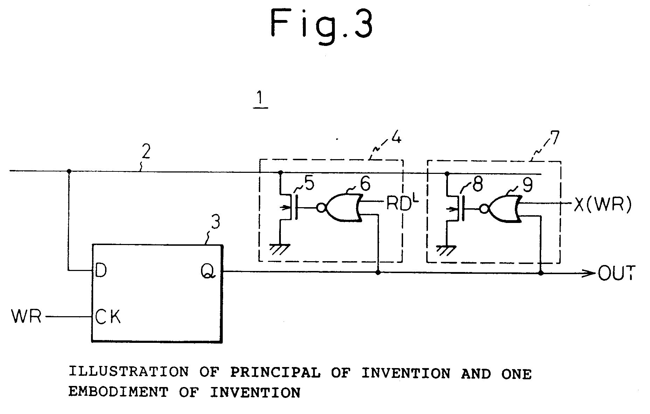

Fig. 3 is a schematic illustration showing the principal of the register circuit according to the present invention, and, in turn, showing the first embodiment of the register circuit of the invention.

The register circuit 1 as shown in Fig. 1 includes a latch circuit 3 for sampling and holding a value of a data bus 2 upon writing, and a register read out circuit 4 to output the output of the latch circuit 3 to the data bus 2 upon reading out. The register circuit 1 also includes a second register read out circuit for outputting the output (Q) of the latch circuit 3 to the data bus 2 at the timing other than the reading out timing, by a predetermined control signal X. The register circuit 1 is designed so that the value of the register 3 can be updated only when the data at a write-in timing has a specific logical level.

In Fig. 3, the data bus 2 is designed for supplying necessary data to the corresponding register 3, and normally takes either the first local level, e.g. "H" level, or the second logical level, e.g. "L" level.

On the other hand, the data bus may have a so-called pre-charge system construction, in which the logical level is set at "H" level while no process is performed, and switched into either "H" or "L" level when data processing for the data of the bit is to be performed. On the other hand, it is also possible to set the logical level opposite the pre-charge system.

The latch circuit 3 in the shown embodiment is a register latch that receives the signal from the data bus 2 through a D input and samples and holds the value of the data bus in response to the write signal WR input to the terminal CK.

On the other hand, between the output Q of the latch circuit 3 and the data bus 2, the register read out circuit 4, to output the output of the latch circuit 3 upon reading out, and the second register read out circuit 7, for outputting the output (Q) of the latch circuit 3 at the timing other than the reading out timing in response to the predetermined control signal X, are provided.

The register read out circuit 4 may have a circuit construction, in which a two input NOR gate 6 having one input is connected to the output (Q) of the latch circuit, and the other input connected to the read out signal RD.

On the other hand, in the shown embodiment, another register read out circuit 7 may be a construction in which the output of the two input NOR circuit 9, connected to the output (Q) of the latch circuit 3 at one terminal and receiving the control signal X to be used when a predetermined bit process is desired to be performed at the other input, is connected to the gate f the transistor connected between the data bus 2 and the ground.

The register read out circuits 4 and 7 may be separated circuits as shown in Fig. 3.

On the other hand, it is also possible to have a construction, in which the output of the two input NOR gate of the output means 7 is connected to the RD input terminal for the read signal RD of the two input NOR gate 6.

Furthermore, the control signal X employed in the shown embodiment may be a signal provided from the control circuit with a special construction. Also, the write signal WR may be employed as the control signal X.

Next, the operation of the shown embodiment of the circuit will be discussed.

In the present invention, in order to improve the defect in the prior art, when only a specific bit in the register composed of a plurality of bits and assuming the data at the bits other than the specific bits are "1" before processing operation, the improvement my be achieved by providing a function so that the data in the bits other than the specific bit will not inadvertently vary into "0".

Although it is naturally desirable not to perform a writing process for the bits other than the specific bits, it is practically impossible to write-in only for the specific bit because the computer performs a writing for all bits simultaneously. Therefore, the present invention performs an operation using the data stored in the register as write data to return the register during the writing process.

Namely, in the present invention, upon a writing process, the data stored in the register is re-written as writing data.

Accordingly, in the present invention, the register performs an operation according to a given program during a normal process, and performs a writing operation to re-write the data stored in the specific bit using a bit process command signal upon processing only the specific bit as set forth above.

Here, it is assumed that, in Fig. 3, the data bus is set at pre-charge type so that the logical level of the data bus is held at "H" level in the normal state.

Accordingly, when the read signal RD is applied to the read signal RD terminal of the two input NOR circuit 6 in the register read out circuit 4, and when the data stored in the latch circuit 3 is 0, the logical level of the data bus is switched from "H" to "L".

In a further @practical embodiment, even when the control signal X, which is output at the same timing as the write signal WR, is applied to the control signal input terminal of the two input NOR circuit 9 of the second register read out circuit 9, for example, the logical level of the data bus is switched from "H" to "L" when the data stored in the latch circuit 3 is 0.

By enabling to drive the data bus even upon writing with the second register read out circuit 7, the register that allows writing only 0 can be realized.

In the foregoing construction, when the writing data is 0, 0 is written to the register latch 3 because the data bus is externally driven at "L" irrespective of the register value before writing.

On the other hand, when the writing data is 1 and the register value before writing is 0, since the data bus is driven to be "L" by the second register read out circuit 7, 0 is written in the register latch 3. Conversely, when the writing data is 1 and the register value before writing is also 1, since the data bus cannot be driven to "L", 1 is written in the register latch 3. Through this process, when the write data is 0, 0 is always written, and when write data is 1, the value before writing is maintained. Namely. the register that can write 0 can be constructed.

Namely, the register circuit according to the invention is suitable for forming a register specialized for resetting.

On the other hand, in the shown embodiment, on the data bus, there is the possibility of interference between the data supplied from the computer and the data fed back to the data bus through the register read out circuit; a principal is taken to provide a higher priority for 0 to avoid such interference.

By combining the register circuits with the construction as set forth above, the register circuit having an appropriate bit number of registers that can process the specific bit without affecting other bits, can be formed.

In the embodiment discussed above, the register read out circuit 4 and the second register read out circuit 7 are illustrated with negative logic of the input signal; it is, of course, possible to employ reverse logic.

Furthermore, in the shown embodiment, discussion has been presented for the case that the data bus 2 is set as a pre-charge type, and it is possible to employ the type in which the logical level of the data bus is preliminarily set at "L".

In addition, in the shown embodiment, though the system providing a higher priority for the data of 0 and the register capable of writing in only 0 is established, it is possible to employ a system providing a higher priority for 1, and establish a register capable of writing in only 1.

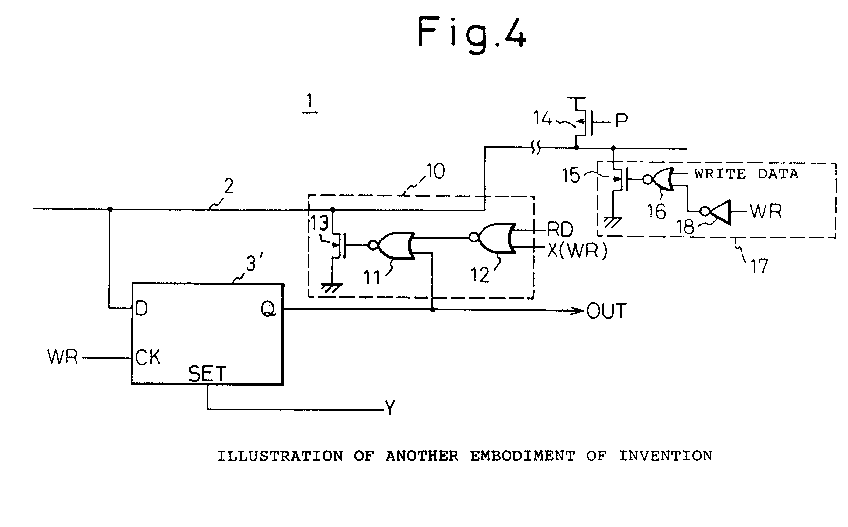

Fig. 4 shows another embodiment of the register circuit according to the present invention.

The embodiment of Fig. 4 is the same as that of Fig. 3 in the basic construction, but the first register read out circuit 4 and the second register read out circuit 7 of Fig. 3 are integrated. Also, Fig. 4 shows an application of the register according to the present invention as a circuit employed in the peripheral circuit of the microcomputer as an interrupt flag circuit to be set by a set signal Y generated when an interrupt condition is satisfied and cleared by writing 0 signal from the CPU of the computer.

In Fig. 4, the latch circuit 3' is formed by adding a set function to the latch circuit 3 of Fig. 3. Also, the register read out circuit 10 is formed by integrally combining the first and second registers 4 and 7 of Fig. 3. The register read out circuit 10 employs the circuit construction in which the output of a two input NOR circuit 12 having one input applied to the read signal RD and the other input receiving the control signal X is connected to one input of a two input NOR circuit 11, which has the other input connected to the output (Q) of the latch circuit 3' and the output connected to the gate of a transistor 13 connected between the data bus.

The register read out circuit 10 is a circuit to drive the logical level of the data bus 2 to "L" by the control signal X generated simultaneously with the write signal WR and with the read signal RD when the data bus 2 is set as a pre-charge type and when the output of the latch circuit 3' is 0.

It should be noted that, in Fig. 4, the transistor 14 forms the pre-charge circuit and provides a function to drive the logical level of the data bus 2 at "H" at the input timing of the pre-charge signal. A circuit 17 including a transistor 15 connected to the data bus and a NOR gate circuit 16 connected with the transistor 15 at the output and having an input to receive the writing data and an inverted signal of the write signal WR via an invertor 18, forms a data output circuit for outputting the writing data to the data bus 2 in response to the write signal.

The operation of this circuit will be discussed herebelow. The data bus 2 is driven to "L" by the data output circuit 17 when the writing data is 0 and by the register read out circuit 10 when the register value before writing is 0. However, when the writing data is 1 and the register value before writing is also 1, the data bus 2 is maintained at H level driven by the pre-charge circuit 14 during a pre-charging period. Therefore, the value to be written in the register latch 3' is constantly 0 as long as the writing data is 0, and is maintained at a value before writing. This type of register is characterized in that, when a certain bit is processed, an adverse effect can be avoided by setting the writing data for bits not related bits in the same register to 1.

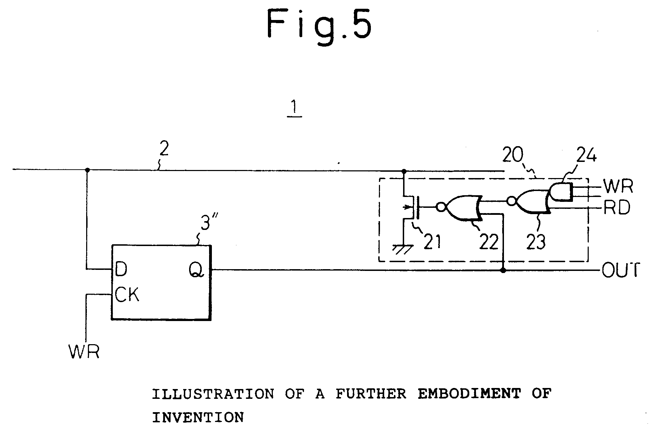

Fig. 5 shows a further embodiment of the register circuit according to the present invention.

In the shown embodiment, the construction of a register read out circuit 20 is made more complicated than the embodiment of Fig. 4.

Namely, the latch circuit 3" in the shown embodiment has the same construction as the latch circuit 3 of Fig. 3, but the register read out circuit 20 employs the circuit construction in which the output of an AND circuit 24 receiving the write signal WR and the control signal X is connected to one input of a two input NOR circuit 23 having the other input receiving the read signal RD; the output of the two input NOR circuit 23 is connected to one input of a two input NOR circuit 22 having the other input connected to the output (Q) of the latch circuit 3", and the output of the NOR circuit 22 is connected to the gate of a transistor connected between the data bus 2 and the ground. By employing the construction set forth above, the write signal WR input to the register read out circuit 20 becomes effective only when the bit process designation signal X is output. By this, during a normal writing operation, re-writing of the register is possible irrespective of the writing data, and when the bit process designation signal is output, the register can re-write the value of the register 3" only when the writing data is 0. This provides a most suitable construction by combining with a CPU outputting only 0 for the bit to be cleared by a bit clear instruction.

In the shown embodiment, by combining a plurality set of register circuits having the construction as set forth above, a register circuit having an appropriate bit number can process only the specific bit without influencing other bits only by outputting one control signal X.

For example, consideration is given for the case, in which four bit data processing is performed with an array of four registers shown in Fig. 5. Here, it is assumed that only the second bit is desired to be re-written, such as to be reset, among the data bus 2 connected to respective first to fourth registers 3"; the data bus connected to the second register is set at the logical level 0 and all of the other data buses are set at the logical level 1.

Next, for control signal X of all circuits, 1 is applied. By this, only the data in the second register is re-written, and the data in other registers can be maintained unchanged.

All of the above-mentioned embodiments are designed to return the out of latch circuit to the data terminal of the latch circuit via the data bus 2 using the predetermined control signal, e.g. X(WR) signal, at a timing other than the read timing so that the random register value can be updated randomly. However, in another aspect of the present invention, it is possible to return the output of the latch circuit to the data terminal of the latch circuit not through the data bus.

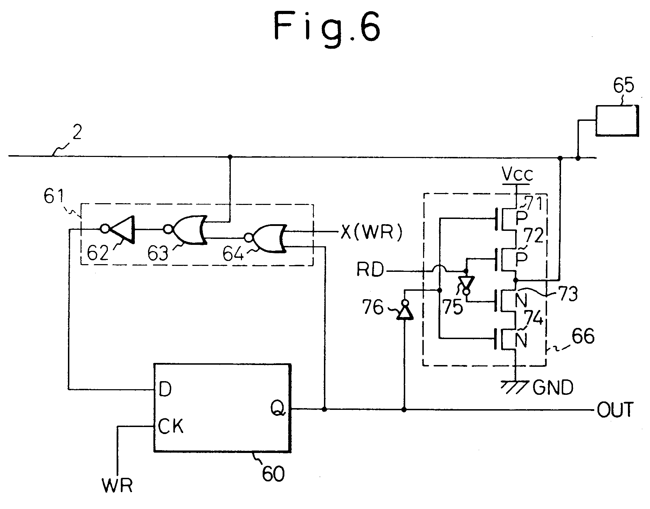

Fig. 6 shows a still further embodiment of the register circuit according to the present invention. The latch circuit 60 in this embodiment is a register latch receiving a signal from the data bus 2 at D input and samples and holds the value of the data bus by the write signal WR input to the terminal CK.

On the other hand, a register read out circuit 66 for outputting the output of the latch circuit 3 to the data bus 2 upon reading, and an arithmetic processing circuit 61 provided with a function for returning the output Q of the latch circuit 60 to the data terminal D of the latch circuit 60 not through the data bus 2 by the predetermined control signal X(WR), are provided between the output Q of the latch circuit 60 and the data bus 2.

The register read out circuit 66 of the shown embodiment may have the same construction as the register read out circuit 4 of Fig. 3. However, as shown in Fig. 6, the register read out circuit 66 can have a circuit construction, in which FET transistors are combined so as to provide high impedance for the circuit 66 at a timing other than the timing of inputting the read signal RD.

Namely, the register read out circuit 66 is constructed with P-channel transistors 71 and 72 and N-channel transistors 73 and 74 arranged successively in series. The P-channel transistor 71 and the N-channel transistor 74 are connected to each other at respective gates. The output Q of the latch circuit 60 is input to the node sections through invertor 76. On the other hand the gates of the P-channel transistor 72 and the N-channel transistor 73 are mutually connected via the invertor 76. The read signal RD, as the control signal, is input to the junction therebetween.

Accordingly, the register read out circuit 66 attains a low impedance by inputting the read signal RD and a high impedance while the read signal RD is not input so as not to output the output Q of the latch circuit 60 to the data bus.

On the other hand, the arithmetic processing circuit 61 includes a NOR circuit 64, to which the output Q of the latch circuit 60 and the predetermined control signal X(WR) to be used at a timing other than the reading timing, are input, for example, a NOR circuit 63 receiving the output of the NOR circuit 64 and the data of the data bus and inputting the output thereof to the data input D of the latch circuit 60 via an invertor 62. In the arithmetic processing circuit, when the predetermined control signal X(WR) is input, the output Q of the latch circuit 60 and the data of the data bus are arithmetically processed to input the resultant data to the data input D of the latch circuit 60 to update the data in the latch circuit 60.

Accordingly, in the arithmetic processing circuit 61, when both the output Q of the latch circuit 60 and the data of the data bus are "0", i.e. "L level", "0", i.e. "L level" data is input to the data input of the latch circuit 60 in response to inputting of the control signal X(WR). On the other hand, when at least one of the output Q of the latch circuit 60 and the data of the data bus is "1", i.e. "H level", "1", i.e. "H level" data is input to the data input D of the latch circuit 60 in response to the control signal X-(WR).

It should be noted that, in the shown embodiment, it is possible to provide a pre-charge circuit with a similar construction as the pre-charge circuit 14 shown in Fig. 4.

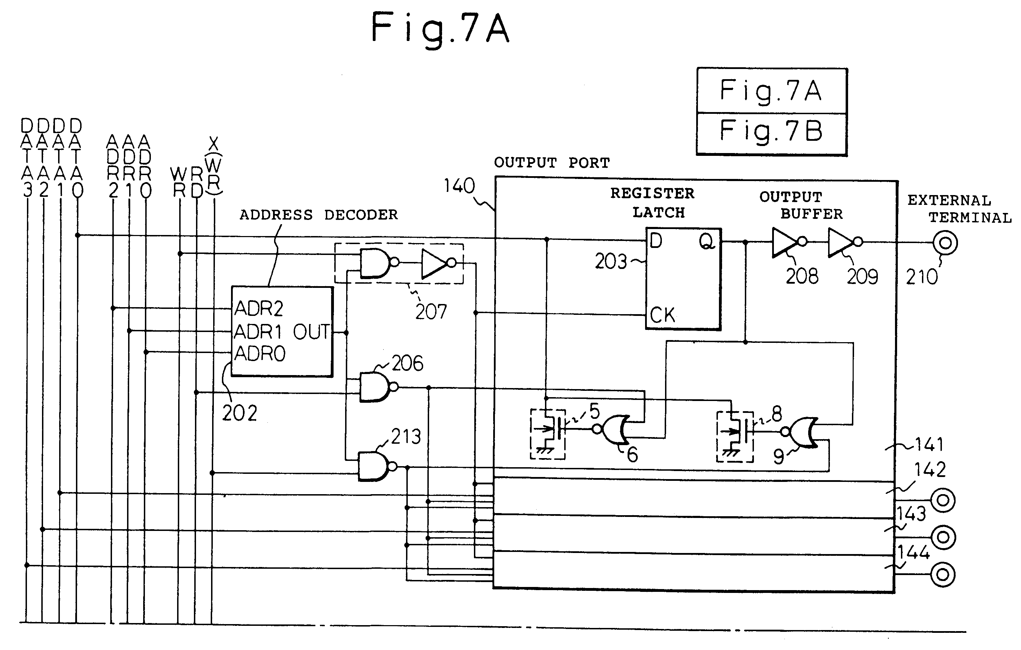

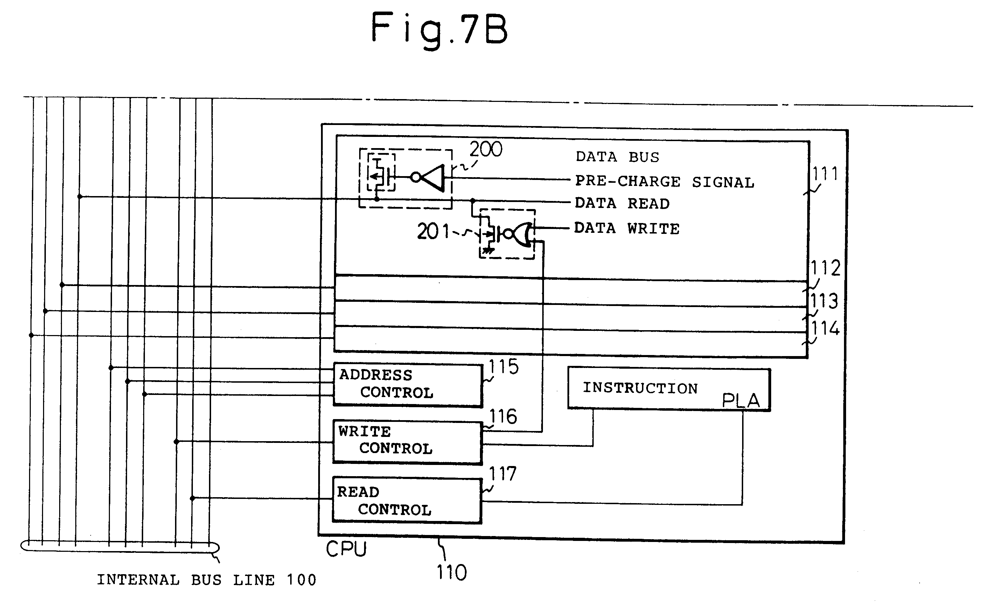

Next, an example of actual application of the register circuit of the present invention to the microcomputer is illustrated in Fig. 7 in a manner corresponding to that of Fig. 2.

Since the basic construction of the microcomputer employed in this embodiment is the same as that of Fig. 2, the discussion for respective components is neglected.

Also, in the shown embodiment, as the register circuit, the register circuit as illustrated in Fig. 3 is employed. Respective components are represented by the same reference numerals as those of Fig. 3.

OPERATION

In the present invention, since the technical construction as set forth above is employed, the logical level corresponding to the data supplied to the data bus is written in the register as long as the data has a specific one logic level by inputting the predetermined control signal, and logic level of the register before writing is maintained as long as the data supplied to the data bus has the other logic level. Accordingly, only one logic level can be written in the register corresponding to the specific bit.

Namely, with the present invention, since only one bit in a plurality of registers can be processed, high speed bit processing can be performed.

## EFFECT OF THE INVENTION

As set forth above, the register, in which the register value is held unchanged when the writing data from the outside, such as CPU, is a specific value, e.g. 1, and which is written only when the writing data is 0, can be made with a simple construction. Also, the reversed operation is also possible. By employing this register, it is possible to provide a register group that can clear the designated bit with one writing operation without reading out the register value, and thus can realize a high speed and compact microcomputer.

Discussing the effect obtained by employing the register circuit according to the present invention in a more practical sense, the bit processing operation in the present invention facilitates a bit process when necessity causes a variation in a certain bit independently of other bits after an address selection of four or eight bits data for processing all together.

Namely, in the four bit data processing operation, if necessity causes a variation in the data for one bit for a changing mode, such as a changing flag, effecting an interrupt when a certain process operation is terminated, repeating the same program, or varying rotation speed or rotating speed at a given state in motor control, and so forth, a complicated circuit construction is required because an address selection for respective registers is required in the prior art. Converse to this, by employing the present invention, it becomes possible to perform this with a simple construction and high efficiency.

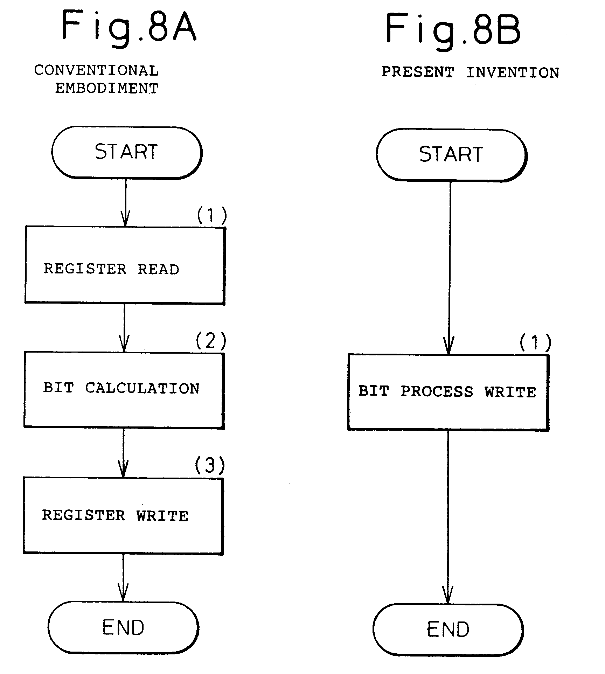

The difference in effect between processing method of the conventional microcomputer and the processing method of the microcomputer employing the present invention is illustrated in Fig. 8.

Fig. 8(A) is a flowchart showing the conventional process. After starting, in a register read at step (1), a CPU reads out the address, outputs the read signal RD and obtains the data from the data bus. Also, the register circuit as the peripheral circuit outputs the data to the data bus.

Step (2) is a bit arithmetic process step in which a CPU performs a bit calculation.

Step (3) is a register write step in which CPU reads out an address, outputs a write signal WR and performs a data output. Also, the register circuit as the peripheral equipment performs an operation to obtain data.

In contrast to the conventional process as set forth above, Fig. 8(B) is a flowchart showing the process steps to be performed y and the microcomputer employing the register circuit according to the present invention. After starting, a process is completed only by a bit processing write operation. In the bit processing write operation, a CPU reads out the address, outputs the X(WR) signal, and performs an output of data. On the other hand, the register circuit as the peripheral equipment performs an operation for obtaining the data.

As is clear from a comparison set forth above, the bit processing step of the microcomputer employing the register circuit can significantly shorten the process steps. Also, it permits a complex process operation at high speed, and efficiency.

## Claims

1.  A register circuit including
    a latch circuit connected to a data bus and obtaining a value of said data bus for holding upon writing; and
    a register read out circuit outputting the output of the latch circuit to said data bus upon reading,
    characterized by a feedback circuit feeding back the output of said latch circuit even at a timing other than the reading timing, by a predetermined control signal.

2.  A register circuit as set forth in claim 1, wherein, in a register including
    a latch circuit connected to a data bus and obtaining a value of said data bus for holding upon writing; and
    a register read out circuit outputting the output of the latch circuit to said data bus upon reading,
    characterized by a second register read out circuit outputting the output of said latch circuit to said data bus even at a timing other than the reading timing, by a predetermined control signal, and by updating a value of the register being performed only when the data at writing is at a specific logic level.

3.  A register circuit as set forth in claim 2, wherein said predetermined control signal is a bit processing designation signal; said register updates the register value irrespective of the writing data during normal writing, and the register value is updated only when the writing data is at a first logic level and the register value is maintained when the writing data is at a second logic level during bit processing.

4.  A register circuit as set forth in claim 1, wherein, in the register including
    a latch circuit connected to a data bus and obtaining a value of said data bus for holding upon writing; and
    a register read out circuit outputting the output of the latch circuit to said data bus upon reading,

characterized by a feedback circuit for feeding back the output of said latch circuit to said latch circuit not through the data bus even at a timing other than the reading timing, by the predetermined control signal.

5. A register circuit as set forth in claim 1, wherein said feedback circuit is responsive to a predetermined signal other than reading out to return data obtained through a process of the output of said latch circuit and the data in said data bus, at a timing other than a reading timing.

6. A microcomputer including a register circuit composed of a plurality of unit register circuits as defined in claims 1 through 5 that input said bit processing designation signal upon bit processing and output a first logic level for a specific bit of said data bus and output a second logic level for other bits of said data bus.

# Fig.1

INTERNAL BUS

100

CPU — 110

RAM — 120

ROM — 130

PORT — 140

| REGISTER | — 141 |
| REGISTER | — 142 |
| REGISTER | — 143 |
| REGISTER | — 144 |

INTERRUPT INPUT — 150

| INTERRUPT REGISTER | — 151 |
| INTERRUPT REGISTER | — 152 |
| INTERRUPT REGISTER | — 153 |
| INTERRUPT REGISTER | — 154 |

TIMER — 160

| OVERFLOW FLAG | — 161 |
| OTHER REGISTER | — 162 |

SERIAL IF — 170

| TRASFER END REGISTER | — 171 |
| OTHER REGISTER | — 172 |

# Fig.2A

OUTPUT PORT

ADDRESS DECODER

REGISTER LATCH OUTPUT BUFFER

EXTERNAL TERMINAL

140

203~  D  Q

CK

208  209  210

ADR2
ADR1 OUT
ADR0

202

207

206

204

205

~141

142

143

144

EP 0 496 002 A1

Fig.2B

# Fig.3

<u>1</u>

ILLUSTRATION OF PRINCIPAL OF INVENTION AND ONE
EMBODIMENT OF INVENTION

# Fig.4

ILLUSTRATION OF ANOTHER EMBODIMENT OF INVENTION

EP 0 496 002 A1

# Fig.5

<u>1</u>

ILLUSTRATION OF A FURTHER EMBODIMENT OF
INVENTION

# Fig.6

# Fig.7A

| Fig.7A |
|--------|
| Fig.7B |

EP 0 496 002 A1

# Fig.7B

DATA BUS
PRE-CHARGE SIGNAL 111
DATA READ
DATA WRITE

200
201

112
113
114

ADDRESS CONTROL 115

WRITE CONTROL 116

READ CONTROL 117

INSTRUCTION PLA

CPU

110

INTERNAL BUS LINE 100

EP 0 496 002 A1

# Fig.8A

CONVENTIONAL
EMBODIMENT

START

(1)

REGISTER READ

(2)

BIT CALCULATION

(3)

REGISTER WRITE

END

# Fig.8B

PRESENT INVENTION

START

(1)

BIT PROCESS WRITE

END

# INTERNATIONAL SEARCH REPORT

International Application No PCT/JP91/01106

### I. CLASSIFICATION OF SUBJECT MATTER (if several classification symbols apply, indicate all) [6]

According to International Patent Classification (IPC) or to both National Classification and IPC

Int. Cl$^5$  G06F9/30, 9/34

### II. FIELDS SEARCHED

| Minimum Documentation Searched [7] | |
|---|---|
| Classification System | Classification Symbols |
| IPC | G06F7/00, 9/30, 9/34, 12/00 |

| Documentation Searched other than Minimum Documentation to the Extent that such Documents are Included in the Fields Searched [8] |
|---|
| Jitsuyo Shinan Koho          1926 - 1990<br>Kokai Jitsuyo Shinan Koho    1971 - 1990 |

### III. DOCUMENTS CONSIDERED TO BE RELEVANT [9]

| Category [*] | Citation of Document, [11] with indication, where appropriate, of the relevant passages [12] | Relevant to Claim No. [13] |
|---|---|---|
| X | JP, A, 1-263819 (Hitachi, Ltd.), October 20, 1989 (20. 10. 89) | 1 |
| Y | JP, A, 1-263819 (Hitachi, Ltd.), October 20, 1989 (20. 10. 89) | 2-6 |
| Y | JP, A, 59-135548 (Toshiba Corp.), August 3, 1984 (03. 08. 84), & US, A, 4747066 | 2-6 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

### IV. CERTIFICATION

| Date of the Actual Completion of the International Search | Date of Mailing of this International Search Report |
|---|---|
| November 1, 1991 (01. 11. 91) | November 18, 1991 (18. 11. 91) |
| International Searching Authority | Signature of Authorized Officer |
| Japanese Patent Office | |

Form PCT/ISA/210 (second sheet) (January 1985)